# EUROPÄISCHE PATENTSCHRIFT

(11) **EP 1 311 868 B1**
(45) Veröffentlichungstag und Bekanntmachung des Hinweises auf die Patenterteilung: **28.05.2008**
(21) Anmeldenummer: 01964900.3
(22) Anmeldetag: 10.08.2001
(51) Int. Cl.: G01R 31/36

(54) **SCHALTUNGSANORDNUNG ZUR ÜBERWACHUNG DES LADEZUSTANDS EINES AKKUMULATORS**
CIRCUIT ARRANGEMENT FOR MONITORING THE STATE OF CHARGE OF AN ACCUMULATOR
CIRCUIT DE CONTROLE DE L'ETAT DE CHARGE D'UN ACCUMULATEUR

(30) Priorität: 12.08.2000 DE 10039472
(43) Veröffentlichungstag der Anmeldung: 21.05.2003
(73) Patentinhaber: ROBERT BOSCH GMBH, 70442 Stuttgart (DE)
(72) Erfinder: SEILS, Wolfgang, 71640 Ludwigsburg (DE); SCHOCH, Eberhard, 70469 Stuttgart (DE); BRAND, Martin, 71638 Ludwigsburg (DE); SCHOETTLE, Juergen, 71706 Markgröningen (DE); WENGER, Christoph, 70825 Korntal-Muenchingen (DE); SCHMUCKER, Clemens, 71732 Tamm (DE)
(86) Internationale Anmeldenummer: PCT/DE2001/003082
(87) Internationale Veröffentlichungsnummer: WO 2002/014887

(56) Entgegenhaltungen:
- EP-A- 0 448 767
- EP-A- 0 665 628
- WO-A-99/01773
- US-A- 5 444 378
- US-A- 5 710 501
- US-A- 5 965 997
- PATENT ABSTRACTS OF JAPAN vol. 2000, no. 01, 31. Januar 2000 (2000-01-31) & JP 11 283677 A (FUJI FILM CELLTEC KK;FUJI PHOTO FILM CO LTD), 15. Oktober 1999 (1999-10-15)

## Beschreibung

### Stand der Technik

Die Erfindung betrifft eine Schaltungsanordnung nach dem Oberbegriff des Anspruchs 1 zur Überwachung des Ladezustands eines Akkumulators, welcher insbesondere in einem Kraftfahrzeug angeordnet ist, mit einem Steuergerät, welches Stromfluß aus dem Akkumulator heraus oder in den Akkumulator hinein erfasst und auswertet.

Eine derartige Schaltungsanordnung wird beispielsweise in Kraftfahrzeugen verwendet, um hierdurch stets den aktuellen Ladezustand des Akkumulators zur Verfügung zu haben. Durch Erfassung des Akkumulatorstroms, der Akkumulatorspannung und - temperatur läßt sich eine relativ genaue Aussage über den Akkumulatorzustand ermitteln. Die Erfassung der genannten Größen sowie die

Ermittlung des Akkumulatorzustands geschieht mittels des Steuergeräts.

Da das Steuergerät vom Akkumulator mit Energie versorgt wird, entlädt es bei stillstehendem Motor und damit nicht erfolgender Erzeugung von elektrischer Energie mittels des in einem Kraftfahrzeug eingebauten Generators den Akkumulator. Um dies zu verhindern, wird das Steuergerät im Ruhezustand des Kraftfahrzeuges ausgeschaltet. Sobald die Zündung ausgeschaltet ist und der Stromverbrauch im Kraftfahrzeug ausreichend abgesunken ist, speichert das Steuergerät den aktuellen Zustand des Akkumulators und schaltet sich dann aus. Erst beim Einschalten der Zündung wird das Steuergerät wieder eingeschaltet.

Da jedoch in heutigen Kraftfahrzeugen häufig Verbraucher vorhanden sind, welche auch im Ruhezustand des Kraftfahrzeuges Energie benötigen, wie beispielsweise eine Kühlbox im Kofferraum des Kraftfahrzeuges, wird dem Akkumulator Strom entnommen, ohne daß dies vom Steuergerät registriert wird. Hierdurch stimmt der vom Steuergerät ermittelte Zustand des Akkumulators nicht mehr mit dem wahren Zustand des Akkumulators überein.

Aus der WO 99/50098 und der US 5 444 378 ist es zwar bekannt, ein Kraftfahrzeug in einen Ruhezustand (Sleep Mode) zu versetzen, um hierdurch den Energieverbrauch zu senken. Aus der letztgenannten Druckschrift lassen sich eine Hinweise auf eine Überwachung des Ladezustands eines Akkumulators entnehmen. Die erstgenannte Druckschrift befasst sich mit einem Überwachungssystem eines Kraftfahrzeuges,
welches Eingänge für mehrere Kraftfahrzeug-Untersysteme hat. Zur Einsparung von Energie wird in der genannten Druckschrift vorgeschlagen, das Kraftfahrzeug in einen Sleep Mode zu versetzen,
wobei Aktivierungssignale (Wake-up-Signale) normalerweise nicht auf die Eingänge der Kraftfahrzeug-Untersysteme gegeben werden.

Während des Sleep Mode werden die Eingänge permanent im Umlauf abgefragt, um hierdurch das Auftreten eines Wake-up-Signals zu erkennen. Tritt nach einer bestimmten Zeit kein Wake-up-Signal auf, wird die Zykluszeit der Abfrageeingänge erhöht. Tritt nach einer weiteren vorbestimmten Zeit immer noch kein Wake-up-Signal an den Eingängen auf, wird die Zykluszeit erneut erhöht. Hierdurch soll der Energieverbrauch während des Sleep Mode verringert werden.

Weiterhin ist aus der DE 41 23 811 A1 ein Verfahren zum Betreiben eines Mikroprozessors bekannt, bei dem der Mikroprozessor durch ein Aktivierungssignal an einem Interrupteingang von einem inaktiven in einen aktiven Betriebszustand schaltbar ist. Nach jedem Eintritt in den inaktiven Zustand wird nach einer vorgebbaren Zeit dem Interrupteingang das Aktivierungssignal zugeführt.

Darüber hinaus ist aus der US-PS 4,965,550 eine Schaltungsanordnung zur kontinuierlichen Überwachung des Status einer Mehrzahl von Schaltern und sogenannten intelligenten Sensoren (Smart-Sensoren), welche mit den Schaltern verbunden sind, bekannt. Jeder Sensor ist mit einem separaten einzelnen Punkt in einem Einzeldraht-Bus verbunden, wobei eine Smart-Sensor-Multiplex-Anordnung, welche einen Wake-up-Schaltkreis darstellt, auf den Sensor einwirkt. Der Wake-up-Schaltkreis ermöglicht die Aktivierung eines jeden Schalters einer Gruppe von Schaltern mit einer hohen Priorität, um einen Mikrokontroller automatisch aus einem Wartezustand in einen aktiven Zustand zu versetzen. Im aktiven Zustand werden alle Schaltkreise des gesamten Systems mit Energie versorgt, woraufhin alle Schalter und Sensormodule im Umlauf abgefragt werden.

Es ist Aufgabe der Erfindung, eine eingangs genannte Schaltungsanordnung derart auszubilden, daß die Genauigkeit der Erfassung des Ladezustands eines Akkumulators erhöht wird.

Die Lösung dieser Aufgabe ergibt sich aus den Merkmalen des kennzeichnenden Teils des Anspruchs 1. Vorteilhafte Weiterbildungen der Erfindung ergeben sich aus den Unteransprüchen.

### Vorteile der Erfindung

Gemäß der Erfindung ist eine Schaltungsanordnung zur Überwachung des Ladezustands eine Akkumulators, welcher insbesondere in einem Kraftfahrzeug eingebaut ist und ein Steuergerät aufweist, welches Stromfluß aus dem Akkumulator heraus oder in den Akkumulator hinein erfasst und auswertet, dadurch gekennzeichnet, daß dass Steuergerät in einen Zustand mit geringem Stromverbrauch (Sleep Mode) versetzbar ist, aus dem es mittels eines Aktivierungssignals wieder herausholbar ist, und ein Sensor vorhanden ist, welcher bei einem Stromfluß aus dem Akkumulator heraus oder in den Akkumulator hinein ein Sensor-Signal abgibt.

Dadurch, daß das Steuergerät in einen Zustand mit geringem Stromverbrauch versetzbar ist, kann das Steuergerät dauernd eingeschaltet bleiben, ohne daß sich hierdurch der Ladezustand des Akkumulators merkbar verändert. Da das Steuergerät mittels eines Aktivierungssignals aus dem Zustand mit geringem Stromverbrauch wieder herausholbar ist, läßt es sich auf einfache Weise wieder in den aktiven Zustand versetzen. Durch den Sensor, welcher bei einem Stromfluß aus dem Akkumulator heraus oder in den Akkumulator hinein ein Sensor-Signal abgibt, läßt sich das Steuergerät somit auf einfache Weise immer dann in den aktiven Zustand versetzen, wenn sich der Ladezustand des Akkumulators durch Stromfluß aus dem Akkumulator heraus oder in den Akkumulator hinein verändert.

Durch die erfindungsgemäße Schaltungsanordnung ist somit gewährleistet, daß das Steuergerät jederzeit eine Veränderung des Ladezustandes des Akkumulators erfasst, ohne daß es sich dauerhaft im aktiven Zustand befindet. Durch die Versetzung des Steuergeräts in den Zustand mit geringem Stromverbrauch während des Ruhezustandes des Kraftfahrzeuges wird in vorteilhafter Weise vermieden, daß sich der Ladezustand des Akkumulators durch Energieentnahme durch das Steuergerät merkbar verändert. Durch die Verwendung eines Sensors, welcher bei einem Stromfluß in der Zuleitung des Akkumulators ein Sensor-Signal abgibt, und dadurch, daß das Steuergerät mittels des Sensor-Signals aus dem Ruhezustand herausgeholt und in den aktiven Zustand versetzt wird, ist eine ununterbrochene Überwachung des Akkumulators möglich, ohne daß hierzu nennenswerte Energie benötigt wird.

In besonders vorteilhafter Weise ist in der Zuleitung des Akkumulators die Primärwicklung eines Transformators geschaltet, wobei es sehr vorteilhaft ist, wenn die Primärwicklung durch die Zuleitung des Akkumulators selbst gebildet ist. Hierdurch läßt sich auf einfache Weise ein Stromfluß in der Zuleitung des Akkumulators detektieren.

Besonders vorteilhaft ist es, wenn der Transformator Bestandteil eines Kompensationsstromsenors ist, mittels dem der Stromfluß aus dem Akkumulator heraus oder in den Akkumulator hinein gemessen wird. Bei einer derartigen Ausführungsform braucht in vorteilhafter Weise zur Erzeugung des Aktivierungssignals des Steuergeräts nahezu kein besonderer Aufwand betrieben werden. Dies wirkt sich sehr günstig auf die Kosten aus. Darüber hinaus wird zur Erzeugung des Aktivierungssignals in der Regel nahezu keine Energie benötigt.

Die genannte Schaltungsanordnung kann noch dadurch verbessert werden, daß das Sensor-Signal zunächst auf einen Komparator gegeben wird. Mittels des Komparators läßt sich das vom Sensor abgegebene Sensor-Signal auf einfache Weise in ein zur Weiterverarbeitung gut geeignetes Signal umwandeln. Da ein Komparator mit geringem Aufwand realisierbar und in einen ASIC integrierbar ist, sind die Kosten einer derartigen Ausführungsform sehr gering. Es könnten aber auch herkömmliche Komparatoren mit integrierter Referenzspannungsquelle, welche als IC auf dem Markt verfügbar sind, verwendet werden. Zur sicheren Erkennung eines Stromsprungs in der Zuleitung des Akkumulators kann eine auf den Komparator folgende digitale Signalverarbeitung vorgesehen sein, durch die der Störabstand der Schaltung erhöht wird.

Weitere Merkmale und Einzelheiten der vorliegenden Erfindung ergeben sich aus der nachfolgenden Beschreibung eines besonderen Ausführungsbeispiels unter Bezugnahme auf die Zeichnung.

### Zeichnung

Es zeigt
- Figur 1: eine erfindungsgemäße Schaltungsanordnung in schematischer Darstellung und
- Figur 2: die in Figur 1 dargestellte Schaltungsanordnung in Verbindung mit einem Kompensationsstromsensor.

### Beschreibung der Ausführungsbeispiele

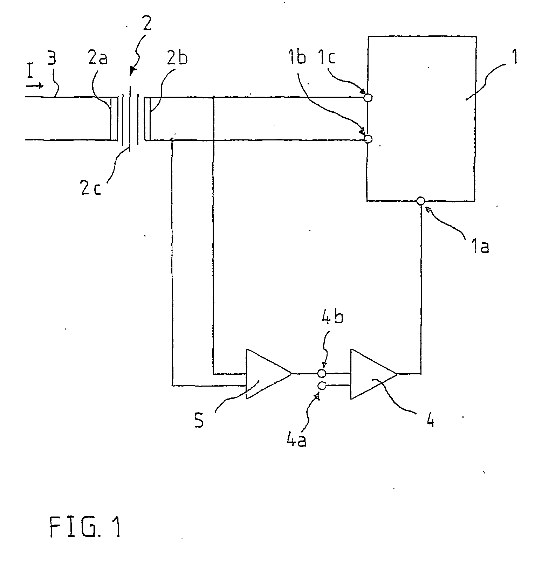

Wie Figur 1 entnommen werden kann, weist ein Steuergerät 1 einen Aktivierungseingang 1a auf, mittels dem das Steuergerät 1 von einem Zustand mit geringem Stromverbrauch wieder aktivierbar ist. Das Steuergerät 1 weist des weiteren zwei Signaleingänge 1b, 1c auf, mittels welcher dem Steuergerät von ihm zu verarbeitende Signale zugeführt werden. Die Steuereingänge 1b, 1c sind im inaktiven Zustand des Steuergeräts 1 hochohmig.

Die in Figur 1 dargestellte Schaltungsanordnung weist des weiteren einen Transformator 2 auf, mit einem Transformatorkern 2c sowie einer Primärwicklung 2a und einer Sekundärwicklung 2b. Die Primärwicklung 2a ist beispielsweise in der Zuleitung 3 eines Kraftfahrzeug-Akkumulators angeordnet.

Die Anschlüsse der Sekundärwicklung 2b sind auf einen Verstärker 5 geführt. Der Ausgang des Verstärkers 5 ist auf den Signaleingang 4b eines Komparators 4 geführt. Am Referenzspannungseingang 4a des Komparators 4 wird eine der gewünschten Schaltschwelle entsprechende Spannung angelegt. Der Ausgang des Komparators 4 ist auf den Aktivierungseingang 1a des Steuergerätes 1 geführt.

Liegt am Aktivierungseingang 1a des Steuergerätes 1 kein Signal an, geht das Steuergerät 1 in einen Zustand mit geringem Stromverbrauch. In diesem Zustand sind die Signaleingänge 1b, 1c hochohmig geschaltet. Der Stromverbrauch der Schaltungsanordnung ist in diesem Zustand sehr gering.

Fließt in der zu überwachenden Leitung 3 und somit durch die Primärwicklung 2a des Transformators 2 ein Strom, wird in der Sekundärwicklung 2b des Transformators 2 eine Spannung induziert. Die induzierte Spannung wird vom Verstärker 5 verstärkt und gelangt auf den Signaleingang 4b des Komparators 4. Ist die vom Verstärker 5 abgegebene Spannung 5 größer als die am Referenzspannungseingang 4a des Komparators 4 anliegende Spannung, gibt der Komparator 4 ein Ausgangssignal ab. Da das Ausgangssignal des Komparators 4 am Aktivierungseingang 1a des Steuergerätes 1 anliegt, wird das Steuergerät 1 vom inaktiven Zustand in den aktiven Zustand geholt. Hierdurch kann es das an den Signaleingängen 1b, 1c anliegende Signal verarbeiten.

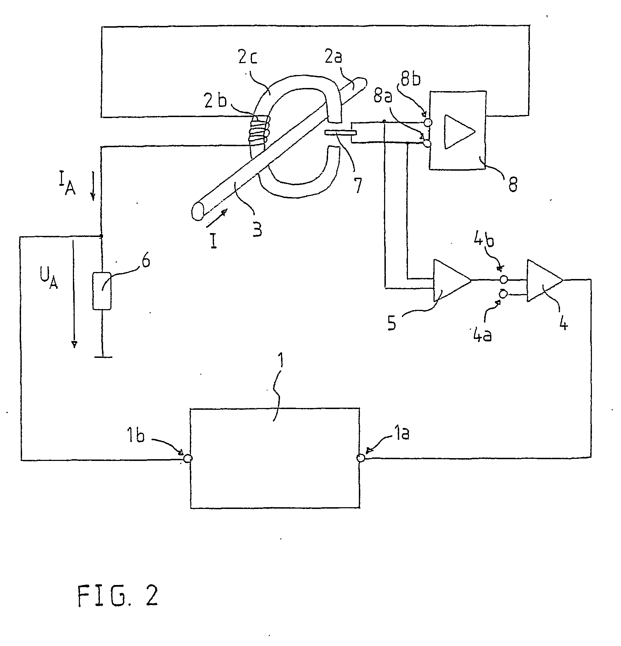

Die in Figur 2 dargestellte Schaltungsanordnung entspricht im wesentlichen der in Figur 1 dargestellten Schaltungsanordnung. Gleiche Bauelemente sind mit gleichen Bezugszeichen versehen.

Bei der in Figur 2 dargestellten Ausführungsform ist der Kern 2c des Transformators 2 als Ringkern mit einem Luftspalt ausgebildet. Die Primärwicklung 2a des Transformators 2 wird durch Zuleitung 3 eines Kraftfahrzeug-Akkumulators gebildet. Die Sekundärwicklung 2b des Transformators 2 ist eine um den Ringkern 2c gewickelte Spule 2b. Im Luftspalt des Ringkerns 2c ist ein Sensorelement 7 zur Erfassung der magnetischen Feldstärke im Luftspalt des Ringkerns 2c angeordnet. Die Signalausgänge des Sensorelements 7 sind auf die Signaleingänge 8a, 8b eines ersten Verstärkers 8 geführt. Der Ausgang 8c des ersten Verstärkers 8 ist mit der Spule 2b verbunden und versorgt diese entsprechend dem Signal des Sensorelements 7 mit Strom. Der vom ersten Verstärker 8 abgegebene Strom ist so groß, daß die magnetische Feldstärke im Luftspalt des Ringkerns 2 nahezu null ist.

Der durch die Spule 2b fließende Strom verursacht an einen in Reihe mit der Spule 2b geschalteten Bürdenwiderstand 6 einen Spannungsabfall U_{A}. Der Spannungsabfall U_{A} ist somit ein Maß für den durch die Zuleitung 3 fließenden Strom. Zur Erfassung des Stroms wird die Spannung U_{A} auf den Eingang 1b eines Steuergerätes 1 gegeben, in dem der durch die Zuleitung 3 fließende Strom erfasst wird.

Die Ausgänge des Sensorelements 7 sind des weiteren auf den Eingang eines zweiten Verstärkers 5 geschaltet. Der Ausgang des zweiten Verstärkers 5 ist mit dem Signaleingang 4b des Komparators 4 verbunden. Am Referenzspannungseingang 4a des Komparators 4 ist eine Referenzspannung gelegt, die die Schaltschwelle des Komparators 4 bildet. Der Ausgang des Komparators 4 ist mit dem Aktivierungseingang 1a des Steuergeräts 1 verbunden.

Liegt am Aktivierungseingang 1a des Steuergeräts 1 kein Signal an, befindet sich das Steuergerät 1 in einem Zustand mit geringem Stromverbrauch. In diesem Zustand ist der Eingang 1b des Steuergeräts 1 hochohmig.

Fließt durch die Zuleitung 3 des Kraftfahrzeug-Akkumulators ein Strom, gibt das Sensorelement 7 eine Spannung ab, welche vom zweiten Verstärker 5 verstärkt wird. Übersteigt die vom zweiten Verstärker 5 abgegebene Spannung die am Referenzspannungseingang 4a des Komparators 4 anliegende Spannung, gibt der Komparator 4 ein Signal ab, wodurch das Steuergerät 1 aktiviert wird. Nach der Aktivierung des Steuergeräts 1 kann das am Eingang 1b anliegende Signal im Steuergerät 1 verarbeitet werden.

Fließt in der Zuleitung 3 kein Strom mehr, wird vom Sensorelement 7 keine Spannung mehr abgegeben, wodurch das am Aktivierungseingang 1a des Steuergeräts 1 anliegende Ausgangssignal des Komparators 4 null wird. Hierdurch geht das Steuergerät 1 in einen Zustand mit geringem Stromverbrauch.

## Patentansprüche

1. Schaltungsanordnung zur Überwachung des Ladezustands eines Akkumulators, welcher in einem Kraftfahrzeug, mit einem Steuergerät (1) zum Erfassen und Auswerten des Stromflusses aus dem Akkumulator heraus oder in den Akkumulator hinein, wobei das Steuergerät (1) in einen Zustand mit geringem Stromverbrauch versetzbar ist, aus dem es mittels eines Aktivierungssignals wieder herausgeholt werden kann und Mittel zur Detektion eines Stromflusses, welche bei einem Stromfluss aus dem Akkumulator heraus oder in den Akkumulator hinein ein Signal, an das Steuergerät (1) abgeben können **dadurch gekennzeichnet, dass** die Mittel zur Detektion eines Stromflusses folgende Elemente umfassen: eine einzige Primärwicklung (2a) eines Transformators (2), die in der Zuleitung (3) des Akkumulators liegt, und eine einzige Sekundärwicklung (2b) des Transformators (2) , deren Enden jeweils mit einem Signaleingang (1b), (1c) des Steuergeräts (1) verbunden sind, wobei die Enden der Sekundärwicklung (2b) zusätzlich über eine Schaltung, die wenigstens einen Verstärker (5) und einen Komparator (4) umfasst, mit dem Aktivierungseingang (1a) des Steuergerätes (1) in Verbindung stehen, wobei jeweils ein Ende der Sekundärwicklung (2b) des Transformators (2) an einen der Eingänge des Verstärkers (5) angeschlossen ist und der Transformator (2) Bestandteil eines Kompensationsstromsensors ist.

2. Schaltungsanordnung zur Überwachung des Ladezustands eines Akkumulators, welcher in einem Kraftfahrzeug mit einem Steuergerät (1), zum Erfassen und Auswerten des Stromflusses aus dem Akkumulator heraus oder in den Akkumulator hinein, wobei das Steuergerät (1) in einen Zustand mit geringem Stromverbrauch versetzbar ist, aus dem es mittels eines Aktivierungssignals wieder herausgeholt werden kann, und Mittel zur Detektion eines Stromflusses, welche bei einem Stromfluss aus dem Akkumulator heraus oder in den Akkumulator hinein ein Signal an das Steuergerät abgeben können, **dadurch gekennzeichnet, dass** die Mittel zur Detektion eines Stromflusses folgende Elemente umfassen: eine einzige Primärwicklung (2a) eines Transformators (2), die durch die Zuleitung (3) eines Akkumulators gebildet wird, und eine Sekundärwicklung (2b) des Transformators (2), deren eine Seite mit dem Signaleingang (1b) des Steuergeräts (1) verbunden ist und zusätzlich über einen Widerstand (6) auf Masse liegt und deren die andere Seite über einen Verstärker (8) mit einem Sensorelement (7) in Verbindung steht, wobei jeweils eine Seite des Sensorelements (7) mit einem Anschluss (8a, 8b) des Verstärker (8) verbunden ist und die Anschlüsse (8a, 8b) des Verstärker (8) über eine Schaltung, die wenigstens einen Verstärker (5) und einen Komparator (4) umfasst, mit dem Aktivierungseingang (1a) des Steuergerätes (1) in Verbindung steht, wobei jeweils einer der Anschlüsse (8a, 8b) des Verstärkers (8) an einen der Eingänge des Verstärkers (5) angeschlossen ist und der Transformator (2) Bestandteil eines Kompensationsstromsensors ist.

3. Schaltungsanordnung nach Anspruch 1 oder 2, **dadurch gekennzeichnet, dass** der Ausgang des Verstärkers (5) mit einem Eingang (4b) des Komparators (4) verbunden ist, an dessen anderem Eingang (4a) eine Referenzspannung anliegt, dessen an Ausgang ein Ausgangssignal abgegeben werden kann, wenn die im Verstärker (5) verstärkte Spannung höher ist als die Referenzspannung.

4. Schaltungsanordnung nach einem der vorhergehenden Ansprüche, **dadurch gekennzeichnet, dass** das Steuergerät (1) in einem Zustand mit geringem Stromverbrauch versetzbar ist, wenn an dessen Eingang (1a) kein Ausgangssignal vom Komparator (4) liegt, und daß das Steuergerät bei anliegendem Ausgangssignal in einen aktiven Zustand gebracht werden kann.

5. Schaltungsanordnung nach einem der vorhergehenden Ansprüche, **dadurch gekennzeichnet, dass** der Signaleingang (1b) oder die Signaleingänge (1b), (1c) des Steuergeräts (1) hochohmig sind, wenn sich das Steuergerät (1) im Zustand mit geringem Stromverbrauch befindet.

## Claims

1. Circuit arrangement for monitoring the state of charge of a rechargeable battery in a motor vehicle, having a control unit (1) for detecting and evaluating the flow of current out of the rechargeable battery or into the rechargeable battery, the control unit (1) being able to be changed to a state with low power consumption, from which it can be removed again using an activation signal, and means for detecting a flow of current, which can pass a signal to the control unit (1) when a current flows out of the rechargeable battery or into the rechargeable battery, **characterized in that** the means for detecting a flow of current comprise the following elements: a single primary winding (2a) of a transformer (2), which is in the feed line (3) of the rechargeable battery, and a single secondary winding (2b) of the transformer (2), the ends of which are respectively connected to a signal input (1b), (1c) of the control unit (1), the ends of the secondary winding (2b) additionally being connected to the activation input (1a) of the control unit (1) via a circuit comprising at least one amplifier (5) and a comparator (4), a respective end of the secondary winding (2b) of the transformer (2) being connected to one of the inputs of the amplifier (5), and the transformer (2) being part of a compensation current sensor.

2. Circuit arrangement for monitoring the state of charge of a rechargeable battery in a motor vehicle, having a control unit (1) for detecting and evaluating the flow of current out of the rechargeable battery or into the rechargeable battery, the control unit (1) being able to be changed to a state with low power consumption, from which it can be removed again using an activation signal, and means for detecting a flow of current, which can pass a signal to the control unit when a current flows out of the rechargeable battery or into the rechargeable battery, **characterized in that** the means for detecting a flow of current comprise the following elements: a single primary winding (2a) of a transformer (2), which is formed by the feed line (3) of a rechargeable battery, and a secondary winding (2b) of the transformer (2), one side of which is connected to the signal input (1b) of the control unit (1) and is additionally connected to earth via a resistor (6), and the other side of which is connected to a sensor element (7) via an amplifier (8), one side of the sensor element (7) respectively being connected to a connection (8a, 8b) of the amplifier (8), and the connections (8a, 8b) of the amplifier (8) being connected to the activation input (1a) of the control unit (1) via a circuit comprising at least one amplifier (5) and a comparator (4), one of the connections (8a, 8b) of the amplifier (8) respectively being connected to one of the inputs of the amplifier (5), and the transformer (2) being part of a compensation current sensor.

3. Circuit arrangement according to Claim 1 or 2, **characterized in that** the output of the amplifier (5) is connected to one input (4b) of the comparator (4), the other input (4a) of which has a reference voltage applied to it, and an output signal can be emitted at the output of said comparator if the voltage amplified in the amplifier (5) is higher than the reference voltage.

4. Circuit arrangement according to one of the preceding claims, **characterized in that** the control unit (1) can be changed to a state with low power consumption if an output signal from the comparator (4) is not present at its input (1a), and **in that** the control unit can be changed to an active state if an output signal is applied.

5. Circuit arrangement according to one of the preceding claims, **characterized in that** the signal input (1b) or the signal inputs (1b), (1c) of the control unit (1) has/have a high impedance when the control unit (1) is in the state with low power consumption.

## Revendications

1. Circuit pour surveiller l'état de charge d'un accumulateur installé dans un véhicule automobile, comportant un appareil de commande (1) pour saisir et exploiter le passage du courant sortant de l'accumulateur ou y entrant,
l'appareil de commande (1) pouvant être mis dans un état à faible consommation de courant à partir duquel il peut être extrait par un signal d'activation et des moyens pour détecter un passage de courant qui, en cas de passage de courant sortant de l'accumulateur ou entrant dans l'accumulateur, génère un signal pour l'appareil de commande (1),
**caractérisé en ce que**
les moyens de détection d'un passage de courant comprennent les éléments suivants :
un unique enroulement primaire (2a) d'un transformateur (2) dans la ligne d'alimentation (3) de l'accumulateur et un unique enroulement secondaire (2b) du transformateur dont les extrémités sont reliées respectivement à une entrée de signal (1b, 1c) de l'appareil de commande (1),
les extrémités de l'enroulement secondaire (2b) sont en outre reliées par un circuit ayant au moins un amplificateur (5) et un comparateur (4) à l'entrée d'activation (1a) de l'appareil de commande (1) et
chaque fois une extrémité de l'enroulement secondaire (2b) du transformateur (2) est reliée à l'une des entrées de l'amplificateur (5) et le transformateur (2) fait partie d'un capteur de courant de compensation.

2. Circuit de surveillance de l'état de charge d'un accumulateur installé dans un véhicule automobile, avec un appareil de commande pour saisir et exploiter le passage du courant sortant de l'accumulateur ou entrant dans l'accumulateur,
l'appareil de commande (1) pouvant être mis dans un état à faible consommation de courant à partir duquel il peut être sorti par un signal d'activation et des moyens pour détecter un passage de courant qui en cas de courant sortant de l'accumulateur ou entrant dans l'accumulateur génèrent un signal destiné à l'appareil de commande,
**caractérisé en ce que**
les moyens de détection du passage du courant comprennent les éléments suivants :
un unique roulement primaire (2a) d'un transformateur (2) formé par la ligne d'alimentation (3) d'un accumulateur et d'un roulement secondaire (2b) du transformateur (2) dont un côté est relié à l'entrée de signal (1b) de l'appareil de commande (1) et qui est en outre relié à la masse par l'intermédiaire d'une résistance (6) et dont l'autre côté est relié par un amplificateur (8) à un élément de capteur (7),
et chaque fois un côté de l'élément de capteur (7) est relié à un branchement (8a, 8b) de l'amplificateur (8) et
les branchements (8a, 8b) de l'amplificateur (8) sont reliés par un circuit ayant au moins un amplificateur (5) et un comparateur (6), à l'entrée d'activation (1a) de l'appareil de commande (1),
et chaque fois l'un des branchements (8a, 8b) de l'amplificateur (8) est relié à l'une des entrées de l'amplificateur (5) et le transformateur (2) fait partie d'un capteur de courant de compensation.

3. Circuit selon la revendication 1 ou 2,
**caractérisé en ce que**
la sortie de l'amplificateur (5) est reliée à une entrée (4b) du comparateur (4) dont l'autre entrée (4a) reçoit une tension de référence dont la sortie peut fournir un signal de sortie lorsque la tension amplifiée dans l'amplificateur (5) est supérieure à la tension de référence.

4. Circuit selon l'une des revendications précédentes,
**caractérisé en ce que**
l'appareil de commande (1) peut être mis dans un état à faible consommation de courant si son entrée (1a) ne reçoit pas de signal du comparateur (4) et si l'appareil de commande est mis par un signal de sortie appliqué dans un état actif.

5. Circuit selon l'une des revendications précédentes,
**caractérisé en ce que**
l'entrée de signal (1b) ou les sorties de signal (1b, 1c) de l'appareil de commande (1) sont fortement ohmiques et l'appareil de commande (1) se trouve dans un état à faible consommation de courant.
